# EUROPEAN PATENT APPLICATION

(11) **EP 1 384 958 A1**
(43) Date of publication of application: **28.01.2004**
(21) Application number: 02707262.8
(22) Date of filing: 29.03.2002
(51) Int. Cl.: F24F 7/06

(54) **PRODUCTION SYSTEM**

(30) Priority: 29.03.2001 JP 2001097168
(71) Applicant: KABUSHIKI KAISHA SANKYO SEIKI SEISAKUSHO, Suwa-gun, Nagano 393-8511 (JP)
(72) Inventor: YASUKAWA, Kazuyoshi, KK SANKYO SEIKI SEISAKUSHO, Suwa-gun, Nagano 393-8511 (JP); UENO, Noboru, KK SANKYO SEIKI SEISAKUSHO, Suwa-gun, Nagano 391-0100 (JP); TSUNETA, Haruhiro, KK SANKYO SEIKI SEISAKUSHO, Suwa-gun, Nagano 391-0100 (JP)
(74) Representative: Dealtry, Brian
(86) International application number: PCT/JP2002/003229
(87) International publication number: WO 2002/079699

(57) **Abstract**

A production system which can provide an operating environment consisting of a clean atmosphere when an environment which can prevent dust from entering is required in an operation such as processing, assembling or the like of a workpiece. A production system (1) comprises: a plurality of mechanical devices (3a to 3g) having workpiece operation sections (4a to 4p) to perform an operation with respect to a workpiece (2); a device for maintaining the workpiece operation sections (4a to 4p) in a clean atmosphere; a carrying device (8) for moving a position of the workpiece (2) in the workpiece operation section (4a to 4p); an operation driving device which drives the carrying means (8) and is provided on the outer side of the workpiece operation section (4a to 4p); and a carriage tube (7) which connects the workpiece operation sections (4a to 4p) of the respective mechanical devices 3 to each other and carries the workpiece (2) from one mechanical device (3a to 3g) to another mechanical device (3a to 3g), thereby reducing a size of an operation area in the production system (1) and facilitating movement and change of a position of the mechanical devices (3a to 3 g) .

## Description

### Technical Field

The present invention relates to a production system. More particularly, the present invention relates to a conformation or a structure of a production system which can provide an operating environment consisting of a clean atmosphere when an environment which can prevent dust from entering is required at the time of a processing operation or an assembling operation of a workpiece.

### Background Art

There has been developed a production system that processes such as carriage of a workpiece or setting of a workpiece to a device are carried out in a clean atmosphere in order to execute processing/assembling operations while assuring a clean environment when manufacturing a motor or the like which has less dust contained therein and a high cleanliness. In this case, since carriage of a workpiece between production devices is also performed in a clean room or a clean booth, measures to suppress generation of dust in a carriage device is taken so that the workpiece itself is carried in the bare state in the clean room.

Thus, in the prior art, when a large workpiece must be carried in such a production system for example, it is convenient to bring and set the production apparatus itself in the clean room.

However, such a production system has a problem that it has a high facility cost since the clean room must have a size large enough for an operator to operate in the room and a clean state which is constantly required must be maintained in the room.

Further, in the production system in the clean environment, the production system itself has a big problem of, e.g., heat generation/dust generation, which disadvantageously leads to an increase in cost or energy for maintaining the environment.

It is, therefore, an object of the present invention to provide a production system which realizes a clean room required for a processing operation or an assembling operation of a workpiece at a low cost.

### Disclosure of Invention

To achieve this aim, according to the present invention, there is provided a production system comprising: a plurality of mechanical devices having workpiece operation sections to perform an operation with respect to a workpiece; means for maintaining a clean atmosphere in the workpiece operation sections; carrying means for moving a position of the workpiece within the workpiece operation section; operation driving means which drives the carrying means and is provided outside the workpiece operation sections; and a carriage tube which connects the workpiece operation sections of the respective mechanical devices to each other and carries the workpiece from one mechanical device to the other mechanical device.

In this production system, in place of maintaining the cleanness of all the atmosphere in the clean room, the clean atmosphere is maintained within an operation area partitioned from the external world so as to operate at least with respect to the workpiece, and a clean environment is formed at a part of the room in a range required for processing/assembling of the workpiece, thereby reducing a cost as compared with a case that the cleanness is maintained in the entire clean room. Therefore, it is possible to produce a motor or the like with the high cleanliness while reducing a cost when forming the clean environment. In this production system, an area required at least for processing, assembling or carriage of the workpiece can be maintained in a sufficient clean atmosphere. Therefore, minimization of the cleaned apparatus is enabled, and a reduction in cost, movement or change of a position of the device can be facilitated. Furthermore, it is not affected by heat generation or dust generation of a work machine, a robot and others.

Moreover, since the workpiece operation sections are connected to each other by a hollow carriage tube, the workpiece which has been subjected to an operation in a given workpiece operation section can be moved to a next workpiece operation section without contacting with outside air. Additionally, a size of the carriage tube connecting the devices can be reduced, and the operation is enabled with a required minimum size and length of the system.

Further, in the production system according to the present invention, it is preferable that the carriage tube is maintained in a clean atmosphere. In this case, the carriage tube is formed by partitioning the clean atmosphere space having a necessary size from the external world, and this space is determined as a movement space required for the workpiece to move from one workpiece operation section to another workpiece operation section in the clean atmosphere. Therefore, according to this production system, the workpiece can be always carried in the clean atmosphere in the processing/assembling operations.

Moreover, in the production system according to the present invention, it is preferable that each mechanical device has a plurality of workpiece operation sections respectively maintained in the clean atmosphere. In this case, a plurality of operations can be performed in a given mechanical device.

Additionally, in the production system according to the present invention, it is preferable that the carrying means accesses the workpiece from the outside of the workpiece operation sections and moves this workpiece. In this case, all the carrying means do not have to be provided in the clean atmosphere. Therefore, the system can be further reduced in size.

Further, according to the present invention, there is provided a production system comprising: work operation sections which are partitioned from an external world to define an operation area for a workpiece and accommodate the workpiece and an operation end of carrying means for moving this workpiece in the operation area; a clean air current generation area which includes cleaning means for maintaining the operation area of the workpiece operation sections in a clean atmosphere; and a mechanism area in which a part or all of operation driving means for driving the carrying means is provided, wherein the production system further comprises a carriage tube which connects the workpiece operation sections with each other and carries the workpiece from one workpiece operation section to another workpiece operation section. According to this production system, it is possible to provide a clean atmosphere in an area which is required and sufficient for processing/assembling or carriage of the workpiece, and minimization of the cleaned device, a reduction in cost and facilitation of movement/change of a position of the device can be realized.

Furthermore, in the production system according to this invention, it is preferable that a partition which includes a small hole maintaining the clean atmosphere on the operation driving means side or a slit allowing movement of the carrying means is provided between the workpiece operation sections and the operation driving means. In this case, the operation area can be maintained so as to have a positive pressure with respect to the mechanism area so that the cleanliness in the operation area can be maintained, a sufficient air flow to the mechanism area formed on the lower side can be assured with less resistance to the clean air, and the dust in the operation area can be readily discharged.

Since this partition distributes the clean air to the operation driving means side through the small hole, the clean atmosphere can be maintained on the operation driving means side.

In this case, it is preferable that at least one of the carriage tube, the operation driving means and carrying means can be attached to the partition. The partition in this case functions as an attachment base of these members, and also serves as a reception base which can receive the workpiece even if this workpiece falls.

Moreover, in the production system according to the present invention, it is preferable that the partition including a small hole which transmits the clean air therethrough or a slit which allows movement of the carrying means is provided between the workpiece operation section and the mechanism area.

In this case, it is preferable that at least any one of the carriage tube, the work driving means and the carrying means can be attached to the partition.

### Brief Description of Drawings

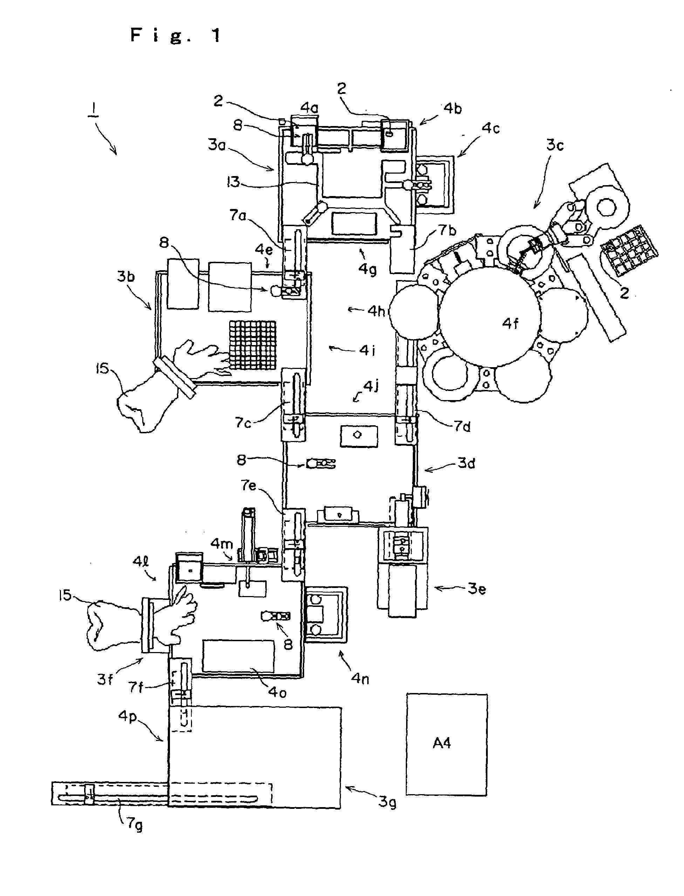

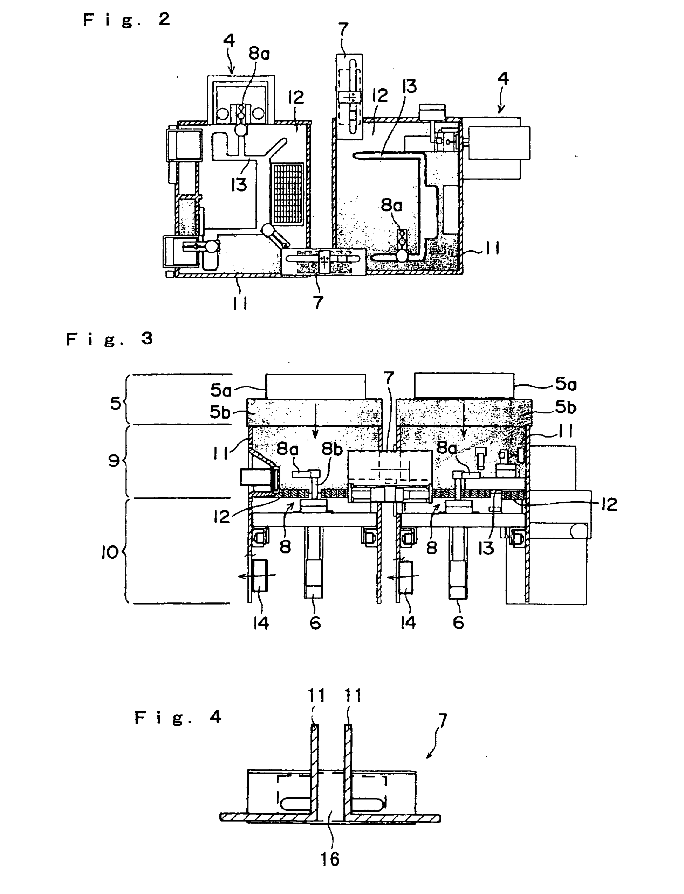

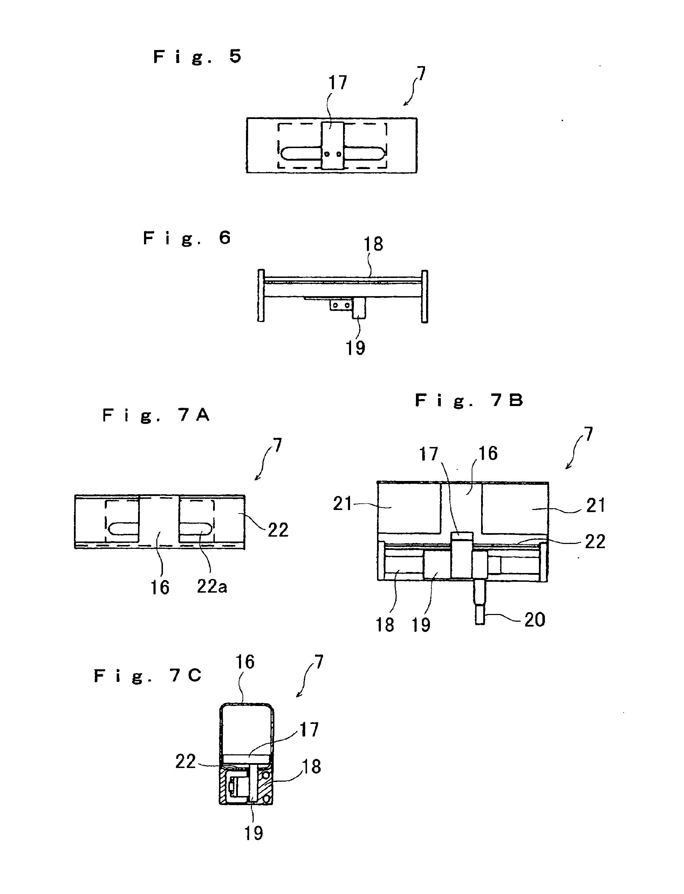

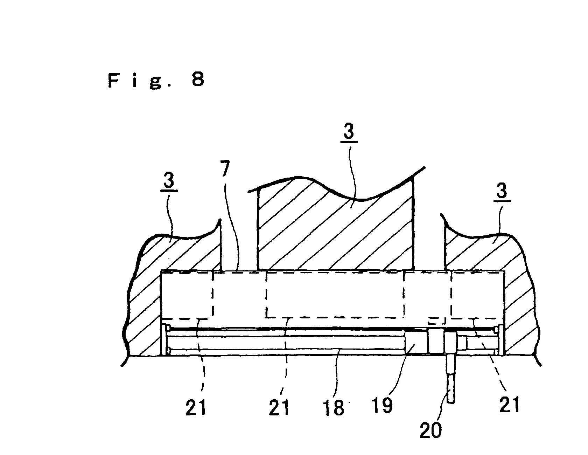

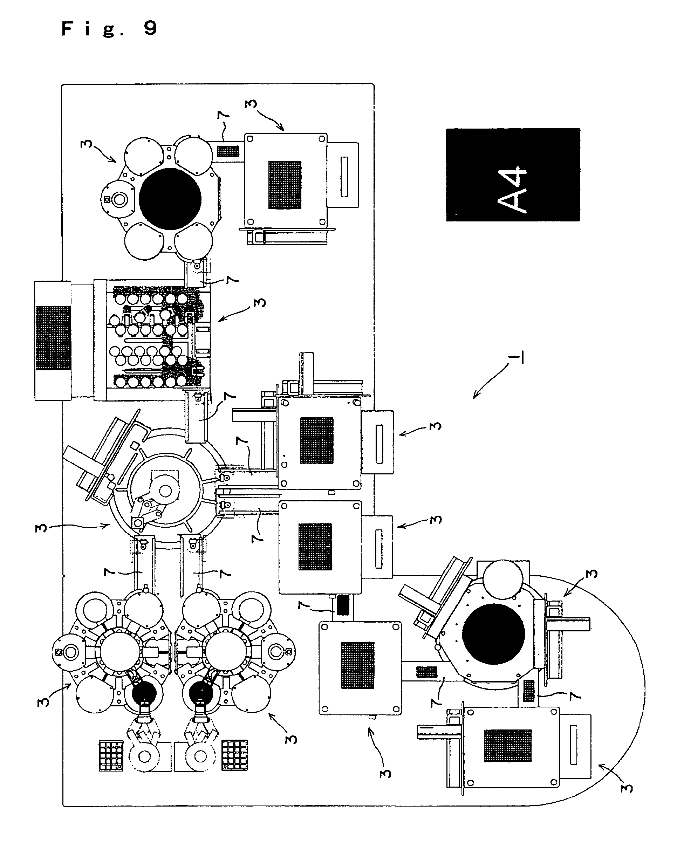

FIG. 1 is a plane view of a production system showing an embodiment of the present invention; FIG. 2 is a plane view showing an example of an internal structure of workpiece operation sections connected by a carriage tube; FIG. 3 is a cross-sectional view from a front side showing an example of the internal structure of the workpiece operation sections connected by the carriage tube; FIG. 4 is a plane view showing side walls and the carriage tube with a cover; FIG. 5 is a plane view showing a structure of the carriage tube from which the side walls and the cover are removed; FIG. 6 is a plane view of the carriage tube showing only a linear motor with a workpiece mount base being removed therefrom; FIG. 7(A) is a plane view showing a structure of the carriage tube with the cover; FIG. 7(B) is a front view showing a structure of the carriage tube with the cover; FIG. 7(C) is a right side view showing a structure of the carriage tube with the cover; FIG. 8 is a view from a front side showing the carriage tube provided so as to cut across three mechanical devices; FIG. 9 is a plane view of a production system showing another embodiment according the present invention.

### Best Mode for Carrying Out of the Invention

A structure of the present invention will now be described in detail based on an illustrated embodiment.

FIGS. 1 to 8 show an embodiment according to the present invention. A production system 1 according to the present invention comprises: a plurality of mechanical devices 3 having workpiece operation sections 4 to perform an operation with respect to a workpiece 2; means 5 for maintaining a clean atmosphere in the workpiece operation sections 4 (which will be referred to as "cleaning means 5" hereinafter); carrying means 8 for moving a position of the workpiece 2 within its workpiece operation section 4; operation driving means 6 for driving the carrying means 8 provided on the outer side of the workpiece operation section 4; and carriage tube 7 for connecting the workpiece operation sections 4 of the respective mechanical devices 3 to each other and carry the workpiece 2 from one mechanical device 3 to another mechanical device 3. It is to be noted that FIG. 1 also shows A4 size paper (210 mm x 297 mm) as a comparison target in order to schematically show a size of the production system 1 according to this embodiment.

An embodiment of the production system 1 for producing a dynamic pressure bearing motor will now be described hereinafter. The production system 1 according to this embodiment includes a plurality of mechanical devices 3 denoted by reference numerals 3a to 3g as shown in FIG. 1. These mechanical devices 3a to 3g are partitioned into three areas, i.e., a clean descending air current generation area constituted of cleaning means 5, an operation area 9 and a mechanism area 10 as shown in FIG. 3, and connected to each other by each of carriage tubes denoted by reference numerals 7a to 7g so as to be shut off from the air outside. A dynamic pressure bearing motor or component parts constituting this as the workpiece 2 appropriately pass through the carriage tubes 7a to 7g and is carried between the respective mechanical devices 3a to 3g.

The respective mechanical devices 3a to 3g have one or more workpiece operation sections 4 such as a shaft supply section 4a, which are independently maintained in a clean atmosphere and have different functions, i.e., respective operation sectors which perform processing/assembling of a dynamic pressure bearing motor as the workpiece 2 on an assembly line. For example, in this embodiment, the mechanical device 3a consists of a shaft supply section 4a, a plate supply section 4b, a shaft press fitting section 4c and a heater section 4d, the mechanical device 3b is constituted of a perpendicularity inspection section 4e, a mechanical device 3c is constituted of a tube cleansing section 4f, the mechanical device 3e is constituted of a tube inside diameter measurement section 4k, the mechanical device 3f is constituted of a bottom bonding/sealing section 4m, a bottom shrink fitting section 4n and a heat section 4o, and the mechanical device 3g is constituted of an oven section 4p. Furthermore, a shaft diameter measurement section 4g, a stock section per framework shaft system 4h, a corresponding framework selection section 4i and a shaft insertion section 4j are provided in a space extending from the mechanical device 3a to the mechanical device 3d. In this case, although each workpiece operation section 4 is basically arranged in a vertical direction along which the workpiece 2 is carried, an additional operation area may be provided in a horizontal direction according to needs.

The cleaning means 5 feeds clean air into the operation area 9 in the clean descending air current generation area and maintains the atmosphere in the workpiece operation section 4 in the clean state. For example, in case of the production system 1 according to this embodiment, the cleaning means 5 consists of a blower 5a which blows out air and a filter 5b which cleans up the blown-out air as shown in FIG. 3, and the operation area 9 is managed to be constantly in a positive pressure state (i.e., state that a positive pressure is obtained) with respect to the outside or the mechanism area 10 by sending the descending air current of the clean air into the operation area 9. Moreover, there is also provided a non-illustrated control structure which variably adjusts a discharge pressure or a discharge quantity of the blower 5a in order to generate an adequate clean processing air current.

The operation area 9 is an operation space in the positive pressure state which has four side walls 11 and the cleaning means 5 attached thereon, and the dynamic pressure bearing motor is processed/assembled in this space where the clean atmosphere is maintained. A size of the operation area 9 can be reduced within a limit required to effect processing/assembling of the workpiece 2. In case of providing a manual operation glove 15 to the workpiece operation section 4, it can be appropriately changed to a necessary size.

The mechanism area 10 has exhausting means 14 and is controlled so as to have a pressure more negative than a pressure in the operation area 9 and a positive pressure above a pressure of the air outside. When the positive pressure above the pressure of the air outside is obtained, the power can be reduced by stopping the exhausting means 14 each time, which is preferable. The mechanism area 10 has a door provided on one or more of the four side walls 11. Additionally, although not shown, a negative pressure source is guided by a tube at a position where a possibility of generation of dust is high at the upper part of the mechanism area 10, and suction is carried out.

Each partition 12 between the operation area 9 and the mechanism area 10 is provided so that the operation area 9 can have a positive pressure with respect to the mechanism area 10 by the operation of the cleaning means 5 and the like in order to prevent air from entering the operation area 9 from the mechanism area 10. It is preferable that this partition 12 has less resistance relative to the clean air flowing from the cleaning means 5 and assures a sufficient flow of air to the mechanism area 10 formed on the lower side. For example, the partition 12 including a plurality of small holes like a grating or a punch metal hardly prevents a flow of the clean air which blows to the mechanism area 10 in order to reduce the air flow resistance. In such a case, the dust in the operation area 9 can be readily discharged outside. Further, a slit 13 is formed to the partition 12 along a movement path of a shaft 8b of the carrying means 8, and has a structure that the operation concerning the necessary work is not prevented. This slit 13 also has a function to facilitate a flow of the clean air when the clean air flowing from the cleaning means 5 blows to the mechanism area 10.

Furthermore, it is preferable that the operation driving means 6, the carriage tube 7, the carrying means 8 or the like can be attached to the partition 12 by utilizing, e.g., a hole formed to the surface thereof. For example, the partition 12 according to this embodiment serves as an attachment base for the carriage tube 7 and the workpiece operation section 4, and has a function to assure the safety by gaining entrance of an operation end 8a of the carrying means 8 thereto and separating the operation end 8a from the drive end of the carrying means 8 and receive the workpiece 2 when the workpiece 2 falls by chance.

Moreover, it is possible to obtain a manual maintenance function by providing to a hole formed to the side wall 11 of the operation area 9 a glove 15 which enables the operation within the operation area 9 while shutting off the air outside. In this case, the partition 12 can serve as an operation base on which a human hand in this groove 15 can be set.

The carrying means 8 is constituted of a device such as a robot which is set so as to perform movement/carriage of the workpiece 2 from the outside of the workpiece operation section 4, at least the operation end 8a such as a tool or a hand is set so as to enter the operation area 9, and this operation end 8a and the operation driving means 6 as a drive source of the carrying means 8 are connected to each other by the shaft 8b. This carrying means 8 accesses the workpiece 2 from the outside of the workpiece operation section 4 (i.e., approaches and grasps) and moves it within the workpiece operation section 4 or between the workpiece operation section 4 and the carriage tube 7. As the operation end 8a, it is possible to adopt any means which has a function to grasp as well as hook or push out the workpiece 2 and which can move the workpiece 2. Additionally, the carrying means 8 itself can be used as means for performing an operation such as caulking or screw-fastening with respect to the workpiece 2 by changing the structure of the operation end 8a.

The carriage tube 7 is inserted into a part between the operation area 9 and the mechanism area 10 and connects the mechanical device 3 on the upstream side with the mechanical device 3 on the downstream side. It is most preferable that the clean atmosphere is maintained inside the carriage tube 7 and the carriage tube 7 can carry the workpiece 2 in the production process from the mechanical device 3 on the upstream side to the mechanical device 3 on the downstream side while maintaining the cleanness. In this case, although an airtight tube which can prevent air outside from entering the operation area 9 is preferable as the carriage tube 7, it is possible to avoid inrush of the dust by obtaining a positive pressure in the operation area 9 even if the complete air-tightness cannot be realized. Additionally, adopting a regimented/standardized joint of the carriage tube 7 is preferable in order to facilitate attachment/detachment. In the production system 1 according to this embodiment, a supply/ejection mechanism used to supply and eject the workpiece 2 to each workpiece operation section 4 is constituted by the carriage tube 7 and the carrying means 8 mentioned above.

In the above-described production system 1, the operation area 9 in which the clean atmosphere is maintained is provided in each mechanical device 3, and the cleanliness management in each mechanical device 3 is independently performed. Additionally, the respective mechanical devices 3 are connected to each other by the carrying tube 7 so that the workpiece 2 is carried. In cases where the production system 1 is constituted by connecting a plurality of the mechanical devices 3 in this manner, if the clean atmosphere is impaired in one mechanical device 3 and a contamination is generated, this contamination may be propagated to other mechanical devices 3 and the entire production system 1 may be polluted, which can result in faults of all the workpieces 2 in the production process. In such a case, a reexamination is required, the operation of the production system 1 must be interrupted to recover the cleanliness, or the system must be again set from the beginning (or together with the these operations), which leads to a large loss. Further, when there is a regular operation such as replenishment or maintenance of the workpiece 2, the cleanliness may be likewise possibly temporarily lowered.

In order to avoid such a loss, the production system 1 detects an abnormal state (i.e., a contamination) of the cleanliness management by individually monitoring the cleanliness of each mechanical device 3. When a contamination is detected from one mechanical device 3, a control operation to prevent propagation to other mechanical devices 3 is performed, and the cleanliness of the other mechanical devices 3 is continuously maintained at that time. Furthermore, the cleanliness of only the mechanical device 3 where the contamination is generated is recovered, the contamination propagation preventing control is canceled when it is detected that the cleanliness of that mechanical device 3 is recovered, and the production system 1 is again activated. The production system 1 having such a structure can quickly recover, minimize the influence to the entire system and realize the rapid reactivation when the contamination is generated (reduction in the cleanliness).

As means for detecting either or both of a reduction in cleanliness and generation of a contamination in each mechanical device 3, there is (1) a method of directly observing the cleanliness by detecting a particle counter or a precipitated particle by image processing or the like. Besides, as (2) a method of detecting the same by an alternative characteristic, there is a method using a pressure measurement device which determines generation of a contamination when the outside of the device and the operation area 9 are compared with each other in air pressure and a positive pressure in the operation area 9 is lower than a fixed level, or a method using a hydrometer or the like which determines generation of a contamination when a current velocity of a down flow is measured and when its current velocity is lowered. Moreover, as a method which can cope with a temporal reduction in cleanliness due to a regular operation such as replenishment or maintenance of the workpiece 2, it is possible to adopt a method which detects opening/closing of the door of the operation area 9 when the door is opened or which turns on a switch as a preliminary procedure when an operator performs maintenance. It is possible to arrange a plurality of these detecting means.

As a control operation which prevents a contamination generated in one mechanical device 3 from propagating to other mechanical devices 3, (1) a pressure in the operation area 9 of the mechanical device 3 from which the contamination is generated is reduced. (2) The clean air is caused to flow from a mechanical device 3 which has not been contaminated and is connected to the operation area 9 of the mechanical device 3. In this case, there is a method of increasing a quantity of down flow of the mechanical device 3 which has not been contaminated, stopping a down flow of the contaminated mechanical device 3, or increasing a speed of an exhaust fan of the contaminated mechanical device 3. Additionally, there is (3) another method of mechanically narrowing an open cross-sectional area of the carriage tube 7 by, e.g., providing a wall portion which divides the carriage tube 7 into two in the carriage direction to the workpiece mount base 17 which moves in the carriage tube 7 and moving the workpiece mount base 17 to a carriage tube connection portion on the contaminated side when a contamination is generated. Of course, it is possible to perform the operation by combining a plurality of the above-described methods.

Here, FIGS. 4 to 8 show the carriage tube 7 using a linear motor. In the example shown in these drawings, the workpiece 2 is mounted on the workpiece mount base 17 and carried from one mechanical device 3 to another mechanical device 3. The carriage tube 7 illustrated in FIG. 4 is a tube with a cover 16 which is provided between the adjacent mechanical devices 3, and the workpiece mount base 17 is provided on the inner side of the cover 16 as illustrated in FIG. 5 showing the state that the cover 16 is removed. Further, as shown in FIG. 6, a stator 18 and a mover 19 of the linear motor are provided on the back side of the workpiece mount base 17. The mover 19 supports the workpiece mount base 17 as shown in FIGS. 7(A) to 7(C), and linearly moves along the stator 18. Reference numeral 20 designates a wire which supplies a power to the linear motor. Furthermore, a part without the cover 16 of the carriage tube 7 is a window 21 opened to the inside of the mechanical device 3, and the carrying means 8 can take out the workpiece 2 through this window 21. Moreover, FIG. 8 shows the carriage tube 7 provided so as to pierce the middle mechanical device 3 and cut across the three mechanical devices 3. A plurality of the windows 21 are provided to the carriage tube 7 in accordance with each mechanical device 3. It is to be noted that the inside of the mechanical device 3 is indicated by hatching only in FIG. 8.

Additionally, as shown in FIG. 7, the carriage tube 7 includes a shield member 22 at the upper part of the linear motor, and a slit 22a is formed to this shield member 22 at a part where the mover 19, which supports the workpiece mount base 17, moves. As a result, the dust or grime generated in the linear motor is prevented from being spread on the workpiece mount base 17 side.

When producing a dynamic pressure bearing motor by using the above-described production system 1, each unit constituting the dynamic pressure bearing motor, e.g., a shaft or a plate is supplied from the side wall 11 of the workpiece operation section 4. Cleansing of the tube is carried out by appropriately changing a direction of the blowout by using, e.g., ultrasonic flowing water which generates ultrasonic waves at a blowout part of a cleansing liquid or scrub cleansing utilizing a brush. It is to be noted that replacement of a chamber itself in the tube cleansing section 4f is possible, but the number of the chambers can be freely set. Further, a shaft diameter is measured after shaft press fitting, and shafts are classified and stocked in accordance with each diameter. Then, an inside diameter of the tube is measured, and a shaft having an inside diameter which matches with the inside diameter is selected and inserted into the tube. Furthermore, the plate is caulked, an adhesive is applied so as to prevent an oil from leaking, and assembling is carried out. Thereafter, the adhesive is molten by heating and adhesion and sealing are carried out. In this case, a plurality of workpieces (motor components) can be baked at a time by heating using an oven like this embodiment. Moreover, at least one workpiece must be always set in the oven, a time is notified by a timer, and a next workpiece is aligned at the tail end in the oven when the baked workpiece 2 is carried from the oven, thereby improving the efficiency.

It is to be noted that the above-described embodiment is a preferred embodiment according to the present invention, but the present invention is not restricted thereto, and various modifications can be carried out without departing from the scope of the invention. For example, the workpiece 2 can be moved through the carriage tube 7 which connects the mechanical device 3 on the upstream side and the mechanical device 3 on the downstream side in this embodiment, but a sealed tray or shuttle can be utilized as means for moving the workpiece 2 in the clean atmosphere. For example, the sealed tray can carry the workpiece 2 while maintaining the clean atmosphere in the tray by adopting a structure which connects the inside air of the operation area 9 by opening the door with a tray open portion cover being appressed against the door of the side wall 11 of the operation area 9.

Another embodiment according to the production system 1 will now be described hereinafter. Although not shown, a clean booth (operation area 9 of each workpiece operation section 4) which applies precision processing in the production system 1 mentioned hereinafter has a size that each side is approximately 30 cm which is smaller than that of the prior art, and each unit (each mechanical device 3) includes cleaning means 5 at the upper portion thereof. When it is configured to blow the clean air toward the lower side through a filter 5b, a necessary air conditioning cost can be greatly reduced as compared with a clean room which maintains the entire room clean. Such a production system 1 can be applicable to a case handling electronic/precision machines as well as articles/commodities requiring a germfree condition in a mass production process of, e.g., food products/medical products. Further, a power supply of the mechanical devices 3 or the carrying means 8 or a special pump or the like which can be a drive source are also included in the mechanism area 10, and hence wiring or pipe fitting can be eliminated. Furthermore, each unit (each mechanical device 3) has one of various functions such as cutting, boring, polishing, assembling, a heating furnace, cleansing and others. Such clean booths are connected to each other in accordance with a manufacturing process, and can constitute a cell type line in a factory in a space whose size is approximately 100 cm x 200 cm. In this case, it is preferable that the unit is of a movable type with casters. Such a production system 1 can change processes by freely recomposing the respective units in accordance with a production item, and activated in a short time when changing the item.

Moreover, means such as a rail for carrying the workpiece 2 between the respective clean booths is arranged in front of or on the side of the clean booths in the state that the respective clean booths are connected to each other, and a pallet having the workpiece 2 mounted thereof can be traveled by an undercarriage or the like. When the workpiece 2 is, e.g., a dynamic pressure bearing motor component and has a small size, it is desirable for the pallet to have a size which is close to a credit card size. The positioning accuracy of the operation base in this case is, e.g., approximately 10 µm. Additionally, the means such as a rail may be accommodated in the above described carriage tube. Further, a member or a component (workpiece 2) can be accommodated in a square case. This square case with a cover being put thereon is inserted into an inlet of the clean booth. In this case, the case is put into the clean booth, then the cover is opened, and thereafter processing is started. Upon completion, the member is put into another case, the cover is put thereon, and the case is carried. The clean environment is maintained in the case.

Furthermore, although FIG. 1 shows an example of the production system in this embodiment, the system conformation is not particularly restricted thereto, and a production system such as shown in FIG. 9 may be configured by free arrangement and combination of the mechanical devices 3 and the carriage tubes 7, or any other conformation may be adopted.

## Claims

1. A production system comprising: a plurality of mechanical devices having workpiece operation sections to perform an operation with respect to a workpiece; means for maintaining a clean atmosphere in the workpiece operation sections; carrying means for moving a position of the workpiece within the workpiece operation section; operation driving means for driving the carrying means, the means being provided on the outer side of the workpiece operation section; and carriage tubes for respectively connecting the workpiece operation section of the respective mechanical devices to each other and carrying the workpiece from one mechanical device to another mechanical device.

2. The production system according to claim 1, wherein the carriage tube is maintained in the clean atmosphere.

3. The production system according to claim 1 or 2, wherein the mechanical device has a plurality of workpiece operation sections which are respectively maintained in the clean atmosphere.

4. The production system according to any one of claims 1 to 3, wherein the carrying means accesses the workpiece from the outside of the workpiece operation section for moving this workpiece.

5. A production system comprising: work operation sections being partitioned from an external world respectively to form an operation area for a workpiece and accommodating in the operation area at least the workpiece and an operation end of carrying means for moving the workpiece; a clean air current generation area including cleaning means for maintaining the operation area of the workpiece operation section in a clean atmosphere; a mechanism area being provided with a part or all of operation driving means for driving the carrying means; and carriage tubes for respectively connecting the workpiece operation section to each other and carrying the workpiece from one workpiece operation section to another workpiece operation section.

6. The production system according to claim 1, wherein a partition including a small hole for maintaining the clean atmosphere on the operation driving means side or a slit for allowing movement of the carrying means is provided between each workpiece operation section and the operation driving means.

7. The production system according to claim 6, wherein at least any one of the carriage tube, the operation driving means and the carrying means can be attached to the partition.

8. The production system according to claim 5, wherein a partition including a small hole for transmitting the clean air current therethrough or a slit for allowing movement of the carrying means is provided between each workpiece operation section and the mechanism area.

9. The production system according to claim 8, wherein at least any one of the carriage tube, the operation driving means and the carrying means can be attached to the partition.
